(19) Europäisches Patentamt / European Patent Office / Office européen des brevets

(11) **EP 4 318 442 A1**

(12) **EUROPEAN PATENT APPLICATION**
published in accordance with Art. 153(4) EPC

(43) Date of publication:
**07.02.2024 Bulletin 2024/06**

(21) Application number: **22779646.3**

(22) Date of filing: **21.02.2022**

(51) International Patent Classification (IPC):
*G09F 9/00* (2006.01)     *G09F 9/30* (2006.01)
*H01L 27/32* (2006.01)     *H05B 33/02* (2006.01)
*H01L 51/50* (2006.01)

(52) Cooperative Patent Classification (CPC):
**G09F 9/00; G09F 9/30; H05B 33/02;** H10K 59/00

(86) International application number:
**PCT/JP2022/006936**

(87) International publication number:
**WO 2022/209419 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2021 JP 2021058696**

(71) Applicant: **Sony Group Corporation**
**Tokyo 108-0075 (JP)**

(72) Inventor: **SATO Kenta**
**Tokyo 108-0075 (JP)**

(74) Representative: **D Young & Co LLP**
**120 Holborn**
**London EC1N 2DY (GB)**

(54) **IMAGE DISPLAY DEVICE AND ELECTRONIC DEVICE**

(57)    To provide an image display device and an electronic device that can suppress a decrease in light transmittance.

The image display device includes:
a plurality of first wiring lines wired in a first layer; a plurality of second wiring lines wired in a second layer different from the first layer and each corresponding to the corresponding one of the plurality of first wiring lines; and a plurality of light emitting elements driven by the plurality of first wiring lines and the plurality of second wiring lines, in which the first wiring line and the second wiring line corresponding to the first wiring line constitute a combination including an overlapping region with respect to a direction starting from a predetermined range of an optical system that receives light or emits light via the plurality of first wiring lines and the plurality of second wiring lines.

FIG. 5

EP 4 318 442 A1

**Description**

TECHNICAL FIELD

The present disclosure relates to an image display device and an electronic device.

BACKGROUND ART

In recent electronic devices such as smartphones, mobile phones, and personal computers (PCs), various sensors such as cameras are mounted in a frame (bezel) of a display panel. The number of mounted sensors also tends to increase, and there are a sensor for face authentication, an infrared sensor, a moving object detection sensor, and the like in addition to cameras. On the other hand, from the viewpoint of design and the tendency of making electronic devices lighter, thinner, shorter, and smaller, an outer size of the electronic device is required to be made as compact as possible without affecting a screen size, causing a bezel width to become narrower. In view of such a background, a technique has been proposed in which an image sensor module is arranged immediately below a display panel, and subject light having passed through the display panel is captured by the image sensor module.

CITATION LIST

PATENT DOCUMENT

Patent Document 1: Japanese Patent Application Laid-Open No. 2011-175962

SUMMARY OF THE INVENTION

PROBLEMS TO BE SOLVED BY THE INVENTION

However, there is a possibility that transmittance of the transmitted light decreases or diffracted light is generated due to opaque wiring lines existing inside the display panel.

Therefore, the present disclosure is to provide an image display device and an electronic device that can suppress a decrease in light transmittance.

SOLUTIONS TO PROBLEMS

In order to solve the above problems, according to one aspect of the present disclosure, there is provided an image display device including:

a plurality of first wiring lines provided in a first layer;
a plurality of second wiring lines provided in a second layer different from the first layer; and
a plurality of light emitting elements connected to the plurality of first wiring lines and the plurality of second wiring lines, in which
the first wiring lines and the second wiring lines has an overlapping region in a part of the first wiring lines and the second wiring lines with respect to a direction starting from a predetermined range of an optical component that receives light or emits light.

The first pixel region may have a pixel that includes:

a first light emitting region having a predetermined light emitting area; and
a first non-light emitting region including a first transmission window configured to transmit visible light,
the second pixel region may have a pixel that includes a second light emitting region having a light emitting area larger than the predetermined light emitting area, and
the third pixel region may have a pixel that includes a third light emitting region having a light emitting area larger than the light emitting area of the second light emitting region.

The first wiring lines and the second wiring lines each corresponding to corresponding one of the first wiring lines may constitute a combination in which a deviation amount of the optical system with respect to an optical axis direction changes according to a difference in the direction.

The first wiring lines and the second wiring lines each corresponding to corresponding one of the first wiring lines may constitute at least one combination in which regions may overlap with each other at least within an optical path range of the optical system with respect to an optical axis direction of the optical system.

There may be further provided:

a plurality of third wiring lines wired in a third layer; and
a plurality of fourth wiring lines wired in a fourth layer different from the third layer and each corresponding to corresponding one of the plurality of third wiring lines,
the third wiring lines and the fourth wiring lines each corresponding to corresponding one of the third wiring lines may constitute a combination including an overlapping region with respect to a direction starting from a predetermined range of the optical system that receives light or emits light via the plurality of third wiring lines and the plurality of fourth wiring lines.

The plurality of first wiring lines and the plurality of second wiring lines extend in a first direction, and the plurality of third wiring lines and the plurality of fourth wiring lines may extend in a second direction different from the first direction.

The first direction may be orthogonal to the second direction.

The plurality of light emitting elements may be arranged in a two-dimensional array, and the plurality of light emitting elements may be arranged in a column or row direction that forms a predetermined angle with the first direction.

The plurality of first wiring lines and the plurality of second wiring lines may be wired in a circular arc shape.

The plurality of first wiring lines and the plurality of second wiring lines may have, in a case where light is incident on the plurality of first wiring lines and the plurality of second wiring lines from a point light source on an optical axis of the optical system, a shape that causes the light to scatter in all directions of a plane orthogonal to the optical axis in a state where a scattering direction is suppressed from being biased.

The plurality of first wiring lines may be signal lines each driving corresponding one of a plurality of light emitting elements, and the plurality of second wiring lines may be constant potential lines each driving corresponding one of a plurality of light emitting elements.

The first wiring lines may be first data lines each driving corresponding one of first light emitting elements, and the second wiring lines may be second data lines each driving a second light emitting element adjacent to the first light emitting element.

The plurality of first wiring lines may be signal lines each driving corresponding one of a plurality of light emitting elements,

the plurality of second wiring lines may be first constant potential lines each driving corresponding one of a plurality of light emitting elements,
the plurality of third wiring lines may be scanning lines each driving corresponding one of a plurality of light emitting elements, and
the plurality of fourth wiring lines may be second constant potential lines each driving corresponding one of a plurality of light emitting elements.

The light receiving device may receive light transmitted through the first pixel region.

In order to solve the above problems, according to one aspect of the present disclosure, there is provided an image display device including:

a plurality of first wiring lines having a circular arc shape and a plurality of second wiring lines having a circular arc shape; and
a plurality of light emitting elements connected to the plurality of first wiring lines and the plurality of second wiring lines, in which
the plurality of first wiring lines and the plurality of second wiring lines have,
in a case where light is incident on the plurality of first wiring lines and the plurality of second wiring lines from a point light source on an optical axis of an optical system that receives light or emits light via the plurality of first wiring lines and the plurality of second wiring lines, a shape that causes the light to scatter in all directions of a plane orthogonal to the optical axis in a state where a scattering direction is further suppressed from being biased.

In order to solve the above problems, according to one aspect of the present disclosure, there is provided an electronic device including:

an image display device; and
a light receiving device including an optical system that receives light or emits light via the image display device, in which
the image display device includes:

a plurality of first wiring lines provided in a first layer;
a plurality of second wiring lines provided in a second layer different from the first layer; and
a plurality of light emitting elements connected to the plurality of first wiring lines and the plurality of second wiring lines, and
the first wiring lines and the second wiring lines have an overlapping region in a part of the first wiring lines and the second wiring lines with respect to a direction starting from a predetermined range of an optical component that receives light or emits light.

In order to solve the above problems, according to one aspect of the present disclosure, there is provided an electronic device including:

an image display device; and
a light receiving device including an optical system that receives light or emits light through the image display device, in which
the image display device includes:

a plurality of first wiring lines having a circular arc shape;
a plurality of second wiring lines having a circular arc shape; and
a plurality of light emitting elements connected to the plurality of first wiring lines and the plurality of second wiring lines, in which
the plurality of first wiring lines and the plurality of second wiring lines have,
in a case where light is incident on the plurality of first wiring lines and the plurality of second wiring lines from a point light source on an optical axis of the optical system via the plurality of first wiring lines and the plurality of second wiring lines, a shape that causes the light to scatter in all directions of a plane orthogonal to the optical axis in a state where a scattering direction is suppressed from being biased.

BRIEF DESCRIPTION OF DRAWINGS

Fig. 1A is a plan view and a cross-sectional view of an electronic device including an image display device according to a first embodiment.
Fig. 1B is a view in which two sensors are arranged side by side on a back surface side on an upper side of a center of a display panel.
Fig. 2A is a cross-sectional view of an image sensor module as an example of a sensor.
Fig. 2B is a cross-sectional view of an image sensor module as another example of a sensor.
Fig. 3 is a view schematically illustrating a sensor and a part of a display panel 2 arranged above the sensor.
Fig. 4 is a plan view schematically illustrating a structure example inside a display panel.
Fig. 5 is a plan view and a front view schematically illustrating a structure example inside another display panel.
Fig. 6 is a diagram illustrating light transmittance of a wiring example 1 illustrated in Fig. 4 and a wiring example 2 illustrated in Fig. 5.
Fig. 7 is a cross-sectional view illustrating an arrangement example of wiring lines with respect to a point in an optical system that receives light or emits light.
Fig. 8 is a view illustrating an example in which first wiring lines and second wiring lines arranged in parallel are arranged so as to be aligned on a projection line.
Fig. 9 is a view illustrating an example in which the first wiring lines and the second wiring lines are arranged so as to be aligned on a projection line.
Fig. 10 is a plan view, a front view, and a side view illustrating a wiring example of the display panel shown in a wider range.
Fig. 11 is a circuit diagram illustrating a basic configuration of a pixel circuit including an organic light emitting diode (OLED).
Fig. 12 is a diagram illustrating an arrangement example of a pixel circuit in the display panel.
Fig. 13 is a diagram illustrating an arrangement example of the pixel circuit in the display panel in a case where Δ is not zero.

Fig. 14 is a circuit diagram illustrating another configuration of the pixel circuit including the OLED.

Fig. 15 is a plan view illustrating an arrangement example of another pixel circuit in the display panel.

Fig. 16 is a plan view illustrating an arrangement example of the another pixel circuit in the display panel in a case where ∆ is not zero.

Fig. 17 is a plan view schematically illustrating a structure example inside the display panel.

Fig. 18 is a plan view and a front view schematically showing another structure example inside the display panel 2.

Fig. 19 is a diagram illustrating light transmittance of a wiring example illustrated in Fig. 17 and a wiring example illustrated in Fig. 18.

Fig. 20 is a diagram illustrating a diffraction simulation for grid-shaped wiring lines and circular arc-shaped wiring lines.

Fig. 21 is a diagram illustrating a diffraction simulation for natural light for the grid-shaped wiring lines and the circular arc-shaped wiring lines.

Fig. 22 is a diagram illustrating a diffraction simulation for another natural light for the grid-shaped wiring lines and the circular arc-shaped wiring lines.

Fig. 23 is a plan view illustrating an arrangement example of a circular arc shape inside the display panel in the pixel circuit.

Fig. 24 is a plan view illustrating an arrangement example of the circular arc shape inside the display panel 2 for the pixel circuit 12a in a case where ∆ is not zero.

Fig. 25 is a view illustrating an internal state of a vehicle from the rear side to the front side of the vehicle.

Fig. 26 is a view illustrating an internal state of the vehicle from the oblique rear side to the oblique front side of the vehicle.

Fig. 27 is a front view of a digital camera as a second application example of the electronic device.

Fig. 28 is a rear view of the digital camera.

Fig. 29 is an external view of a head-mounted display (HMD) as a third application example of the electronic device.

Fig. 30 is an external view of a smart glass.

Fig. 31 is an external view of a television (TV) as a fourth application example of the electronic device.

Fig. 32 is an external view of a smartphone as a fifth application example of the electronic device.

MODE FOR CARRYING OUT THE INVENTION

Hereinafter, embodiments of an image display device and an electronic device will be described with reference to the drawings. Although principal components of the image display device and the electronic device will be mainly described below, the image display device and the electronic device may include components and functions that are not illustrated or described. The following description does not exclude components and functions that are not illustrated or described.

(First embodiment)

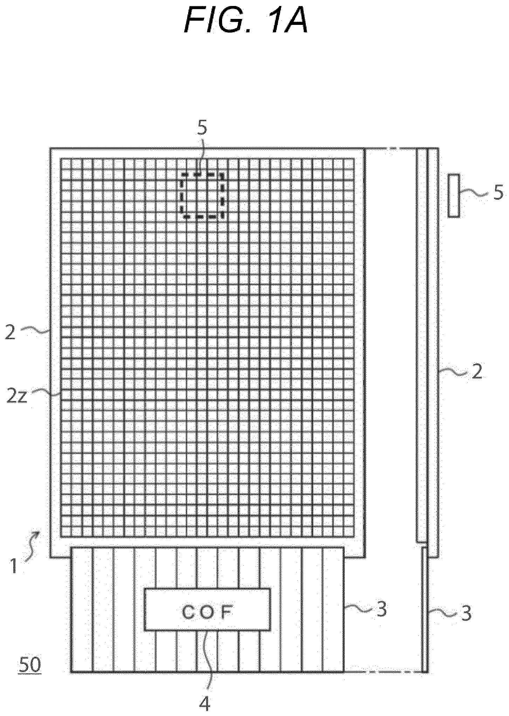

Fig. 1A is a plan view and a cross-sectional view of an electronic device 50 including an image display device 1 according to a first embodiment of the present disclosure. As illustrated, the image display device 1 according to the present embodiment includes a display panel 2. For example, a flexible printed circuit (FPC) 3 is connected to the display panel 2. The display panel 2 is obtained by laminating a plurality of layers on, for example, a glass substrate or a transparent film, and a plurality of self light emitting elements and wiring lines that drive the plurality of self light emitting elements are arranged vertically and horizontally on a display surface 2z. A chip on film (COF) 4 incorporating at least a part of a drive circuit of the display panel 2 is mounted on the FPC 3. Note that the drive circuit that drives the plurality of self light emitting elements via the wiring lines may be laminated on the display panel 2 as a chip on glass (COG).

In the image display device 1 according to the present embodiment, various sensors 5 that receive light through the display panel 2 can be arranged immediately below the display panel 2. In the present description, a configuration including the image display device 1 and the sensor 5 is referred to as the electronic device 50. While a type of the sensor 5 provided in the electronic device 50 is not particularly limited, examples of which include, for example, an imaging sensor 5 that photoelectrically converts light incident through the display panel 2, a distance measuring sensor 5 that projects light through the display panel 2 and receives light reflected by a target object through the display panel 2 to measure a distance to the target object, a temperature sensor 5 that measures a temperature on the basis of light incident through the display panel 2, and the like. In this way, the sensor 5 arranged immediately below the display panel 2 has at least a function of a light receiving device that receives light via a light receiving optical system. Note that the sensor 5 may have a function of a light emitting device that emits light via a light emitting optical system through the display panel 2.

In Fig. 1A, an example of a specific location of the sensor 5 arranged immediately below the display panel 2 is indicated by a broken line. As illustrated in Fig. 1A, for example, the sensor 5 is arranged on a back surface side on an upper side of the center of the display panel 2. Note that the arrangement location of the sensor 5 in Fig. 1A is an example, and any arrangement location of the sensor 5 may be adopted. By arranging the sensor 5 on the back surface side of the display panel 2, the sensor 5 does not need to be arranged around the display panel 2, a bezel of the electronic device 50 can be minimized, almost the entire region on the front side of the electronic device 50 can be used as the display panel 2, and the outer size of the electronic device 50 can be reduced without having an area of the display panel 2 reduced.

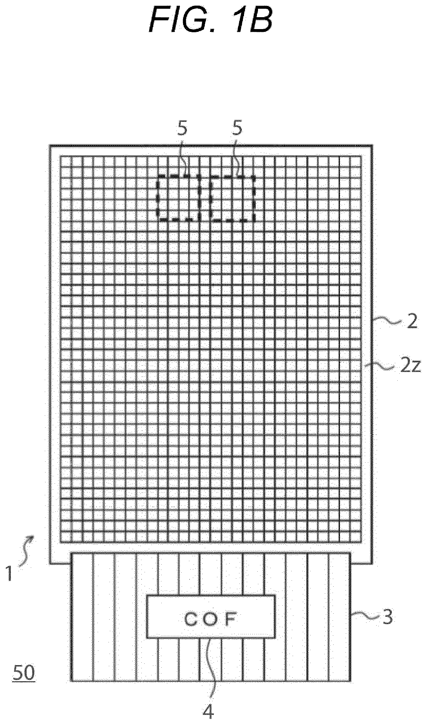

Fig. 1B is a view in which two sensors are arranged side by side on the back surface side on the upper side of the center of the display panel. The drawing illustrates an example in which two sensors 5 are arranged side by side on the back surface side on the upper side of the center of the display panel 2. Fig. 1A illustrates an example in which the sensor 5 is arranged at one place of the display panel 2, but the sensor 5 may be arranged at a plurality of places as illustrated in Fig. 1B.

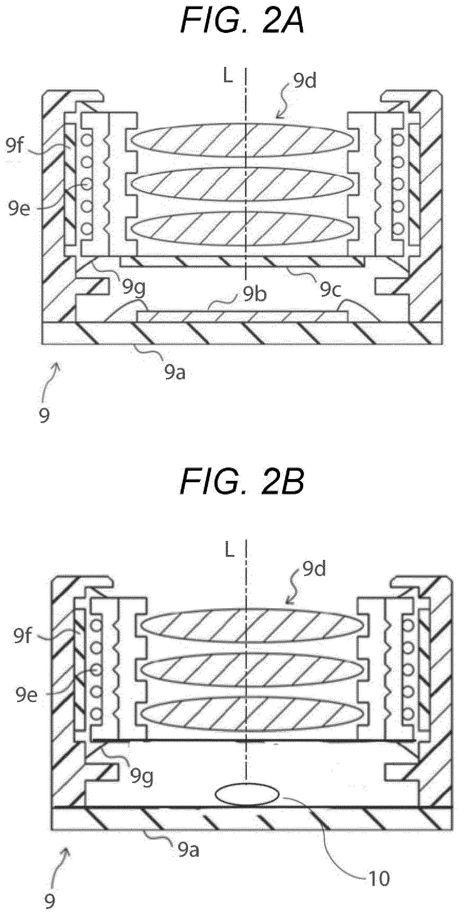

Fig. 2A is a cross-sectional view of an image sensor module 9 which is an example of the sensor 5. As illustrated in Fig. 2A, the image sensor module 9 includes an image sensor 9b mounted on a support substrate 9a, an infrared ray (IR) cut filter 9c, a lens unit 9d (light receiving optical system), a coil 9e, a magnet 9f, and a spring 9g. The lens unit 9d includes one or a plurality of lenses. The lens unit 9d is movable in an optical axis L direction in accordance with a direction of an electric current flowing through the coil 9e. Note that the internal configuration of the image sensor module 9 is not limited to that illustrated in Fig. 2A.

Fig. 2B is a cross-sectional view of an image sensor module 9 which is another example of the sensor 5. As illustrated in Fig. 2B, the image sensor module 9 includes a light emitting element 10 mounted on a support substrate 9a, a lens unit 9d (light emitting optical system), a coil 9e, a magnet 9f, and a spring 9g. The lens unit 9d includes one or a plurality of lenses. The lens unit 9d is movable in an optical axis L direction in accordance with a direction of an electric current flowing through the coil 9e. Note that the internal configuration of the image sensor module 9 is not limited to that illustrated in Fig. 2B.

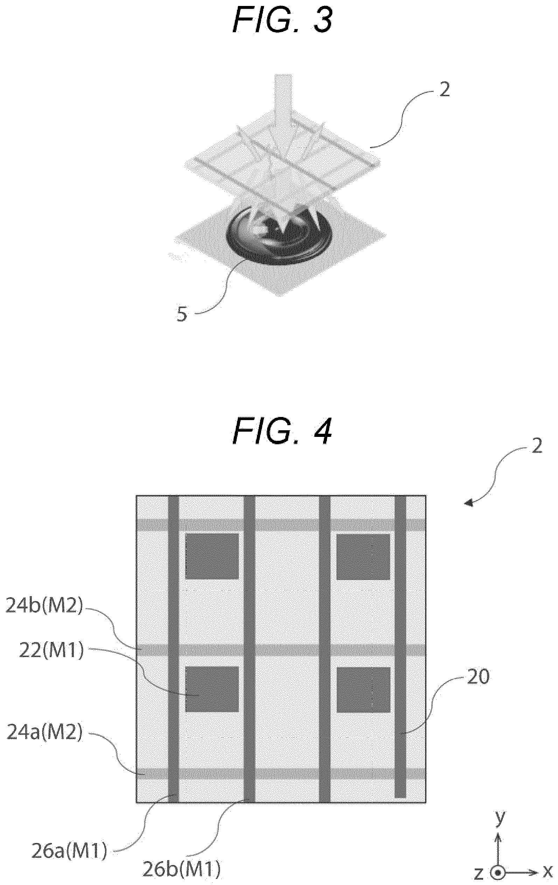

Fig. 3 is a view schematically illustrating the sensor 5 and a part of the display panel 2 arranged above the sensor 5. As illustrated in Fig. 3, the wiring lines disposed on the display panel 2 is opaque, which hinders incident light entering the sensor 5 or emitted light emitted from the sensor 5. For example, light is reflected or diffracted by the wiring lines.

Fig. 4 is a plan view schematically illustrating a structure example inside the display panel 2. A self light emitting element 22 is, for example, an organic electroluminescence (EL) element (hereinafter, also referred to as an organic light emitting diode (OLED)). Regarding the self light emitting element 22, because a backlight can be omitted, at least a part of the display panel 2 can be made transparent. Hereinafter, an example in which the OLED is used as the self light emitting element will be mainly described. The self light emitting element 22 is disposed in a layer M1. In Fig. 4, an upper layer of the display panel 2 is defined as M1, and a lower layer is defined as M2. That is, the lower layer M2 is a layer on the sensor 5 side.

As illustrated in Fig. 4, in the display panel 2 using the organic EL element, opaque wiring lines 24a, 24b, 26a, and 26b such as a power supply line and a scanning line for light emission control of each self light emitting element 22 are scanned inside the transparent substrate in the vertical and horizontal directions. In this manner, the plurality of self light emitting elements 22 is arranged in a two-dimensional array. The wiring lines 24a and 24b extend in the first direction, are arranged in the layer M2, and are used for driving the self light emitting elements 22. Similarly, the wiring lines 26a and 26b extend in the second direction different from the first direction, are arranged in the layer M1, and are used for driving the self light emitting elements 22. For example, the first direction and the second direction are orthogonal to each other.

In this manner, the wiring lines are arranged so as not to be in contact with each other. That is, in the same z position (in the same layer), the wiring lines are arranged at different positions in the xy plane (in the plane viewed from above the display). On the other hand, in a case where the wiring lines overlap with each other in the xy plane, the z positions thereof are arranged to be different from each other. In a case where the number of wiring line layers is reduced, the number of lamination processes is generally reduced to allow the manufacturing cost to be reduced. On the other hand, the wiring lines in each layer have less portions that can overlap with each other in the xy plane, and the aperture ratio decreases.

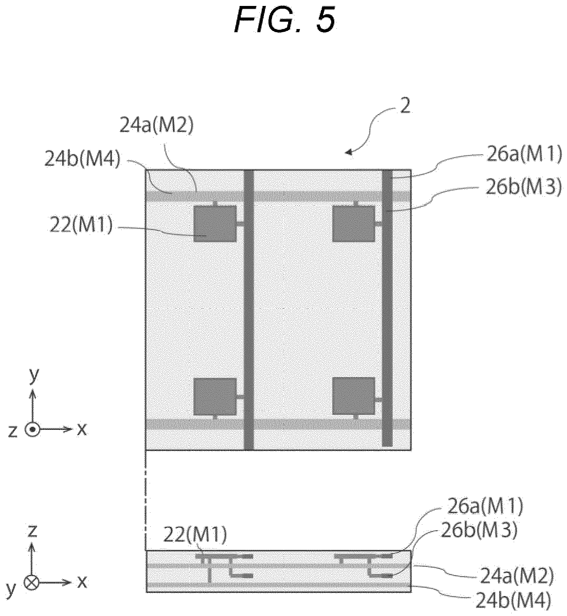

Fig. 5 is a plan view and a front view schematically showing another structure example inside the display panel 2. Layers M1, M2, M3, and M4 are set in this order from the upper layer of the display panel 2. As illustrated in Fig. 5, the wiring lines 24a and 24b extend in the first direction and are arranged in the layer M2 and the layer M4, respectively. The wiring lines 24a and 24b are arranged so as to overlap with each other in a case where the wiring lines are viewed from above. Meanwhile, the wiring lines 26a and 26b extend in the second direction different from the first direction and are arranged in the layer M1 and the layer M3, respectively. The wiring lines 26a and 26b are arranged so as to overlap with each other in a case where the wiring lines are viewed from above. As can be seen from these, the wiring lines 24a and 24b are arranged in different layers and overlapped with each other, and the wiring lines 26a and 26b are arranged in different layers and overlapped with each other. Note that the first direction may be determined so as to have a predetermined angle with the row direction of the plurality of self light emitting elements 22 arranged in a two-dimensional array. Similarly, the second direction may be determined so as to have a predetermined angle with the column direction of the plurality of self light emitting elements 22 arranged in a two-dimensional array.

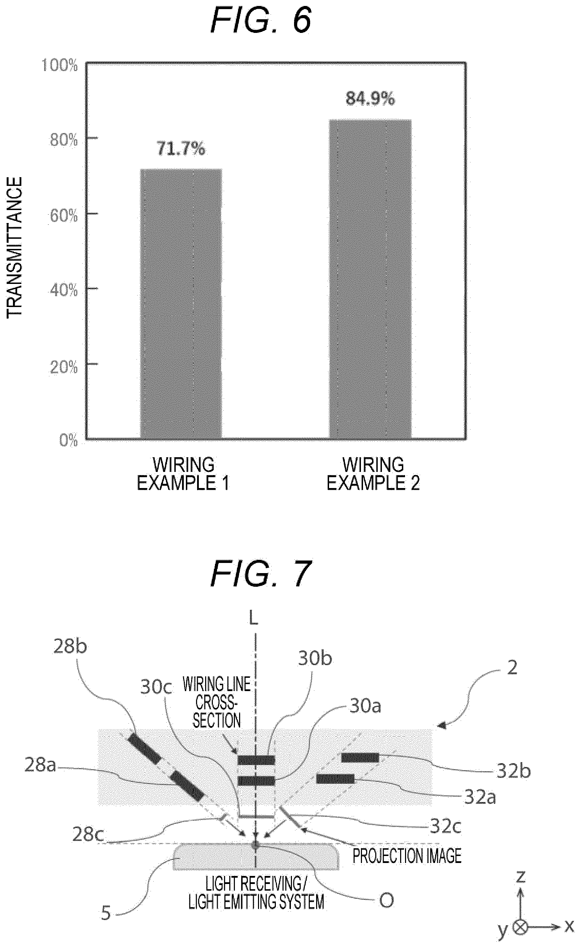

Fig. 6 is a diagram illustrating light transmittance of a wiring example 1 illustrated in Fig. 4 and a wiring example 2 illustrated in Fig. 5. The vertical axis represents light transmittance per unit area. For example, the transmittance is data obtained in a case where light having a wavelength of 550 nm is perpendicularly incident on the display panel 2. As can be seen, by overlapping the wiring lines 24a and 24b with each other and overlapping the wiring lines 26a and 26b with each other, the transmittance is improved from 71.7 percent to 84.9 percent. As described above, by arranging the wiring lines 24a and 24b in different layers and overlapping the two with each other, and arranging the wiring lines 26a and 26b in different layers and overlapping the two with each other, the aperture ratio of the display panel 2 can be increased.

Fig. 7 is a cross-sectional view illustrating an arrangement example of the wiring lines with respect to a point O in an optical system that receives light or emits light. The point O is, for example, a point on an image plane on an optical axis L of the optical system that receives light or emits light. In the plurality of wiring lines that is present in different layers, the plurality of wiring lines is arranged such that projection images in the light receiving/light emitting optical system direction overlap with each other. That is, a first wiring line 28a and a second wiring line 28b are arranged such that projection images 28c thereof with respect to the point O on the surface overlaps with each other. In other words, the combination of the first wiring line 28a and the second wiring line 28b has an overlapping region with respect to a direction starting from the point O, which is a predetermined range of the optical system that receives light or emits light via the first wiring line 28a and the second wiring line 28b. Note that, in Fig. 7, the predetermined range is indicated by a dot, but the present invention is not limited thereto. For example, the predetermined range may be a surface having a predetermined area.

Similarly, wiring lines 30a and 30b are arranged such that projection images 30c thereof with respect to the point O on the surface overlaps with each other. Similarly, wiring lines 32a and 33b are arranged such that projection images 32c thereof with respect to the point O on the surface overlaps with each other. With this arrangement, for example, the area of the projection image to the point O on the optical axis of the optical system can be further reduced. Therefore, the reflection of the two wiring lines on the optical system can be further reduced.

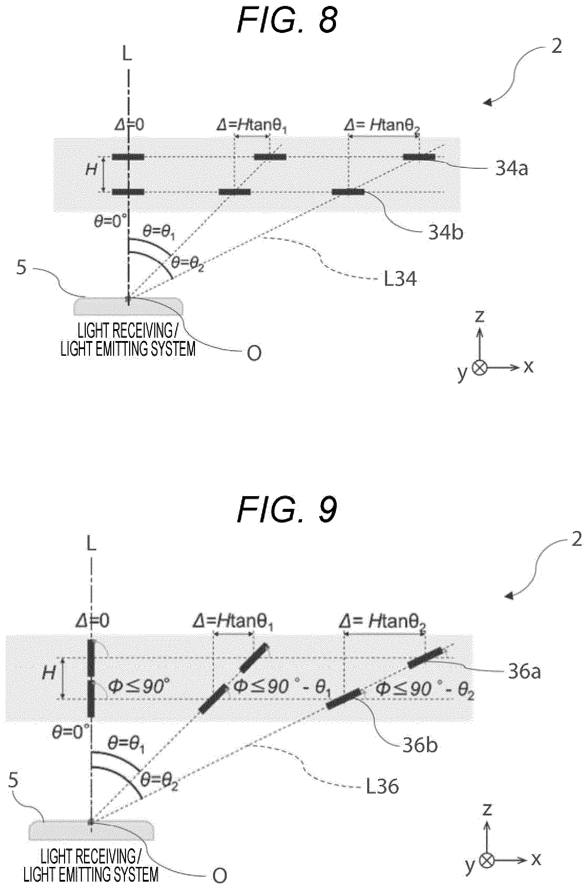

The overlapping manner of the wiring lines will be geometrically described in more detail with reference to Figs. 8 and 9. Fig. 8 is a view illustrating an example in which a first wiring line 34a and a second wiring line 34b arranged in parallel in the xy plane are arranged so as to be aligned on a projection line L34. Fig. 9 is a view illustrating an example in which a first wiring line 36a and a second wiring line 36b are arranged so as to be aligned on a projection line L36.

[Mathematical formula 1]

$$\Delta = H \tan \theta \qquad (1)$$

[Mathematical formula 2]

$$0 \le \phi \le 90° - \theta \qquad (2)$$

As illustrated in Fig. 8, in the combination of the first wiring line 34a and the second wiring line 34b, assuming that the interval in the z direction is H and the angle formed by the optical axis L of the light receiving/light emitting optical system and the wiring line cross-sectional center is $\theta$, a deviation amount (offset amount) $\Delta$ with respect to the direction of the optical axis L changes according to the formula (1) depending on the difference of $\theta$. Here, it is assumed that the thickness of the wiring line is sufficiently thin with respect to the width of the wiring line. In other words, by arranging the first wiring line 34a and the second wiring line 34b so as to have the offset amount $\Delta$ represented by the formula (1), the projection images of the first wiring line 34a and the second wiring line 34b are arranged at positions overlapping with each other. For example, $\theta$ is 0° and $\Delta = 0$ immediately above the light receiving/light emitting system. That is, a region of the first wiring line 34a and a region of the second wiring line 34b overlap each other at least within an optical path range of the light receiving/light emitting optical system with respect to the optical axis L direction of the light receiving/light emitting optical system. With this arrangement, it is possible to improve the transmittance of light for the component transmitted in the direction substantially perpendicular to the light receiving system or emitted in the direction perpendicular to the light emitting system.

As illustrated in Fig. 9, considering the overlapping between the first wiring line 36a and the second wiring line 36b, by setting $\Delta = H\tan\theta 1$ at a position located in the direction of an angle $\theta 1$ from the z axis with respect to the light receiving/light emitting optical system, and by setting $\Delta = H\tan\theta 2$ at a position of an angle $\theta 2$, it is possible to further improve the transmittance of the light incident from the oblique direction. Moreover, as shown in the formula (2), the projection image area can be further reduced by providing an inclination $\Phi$ in the wiring line. That is, by providing the angle $\theta 2$ in the wiring line within the range of the formula (2), an effect of reducing the projection image area is obtained, and the projection image area becomes smaller as the value approaches the maximum value in the range of the above formula. The number of wiring lines to be overlapped per unit wiring structure is not limited to two. For example, the number of wiring lines may be three or more. Furthermore, regarding the overlapping manner of the wiring lines, in a case where the wiring lines are scanned in the longitudinal direction and the lateral direction, only the wiring lines in the longitudinal direction may be overlapped with each other. Alternatively, only the wiring lines in the lateral direction may be overlapped with each other. Alternatively, both the wiring lines in the longitudinal and lateral directions may be overlapped with each other.

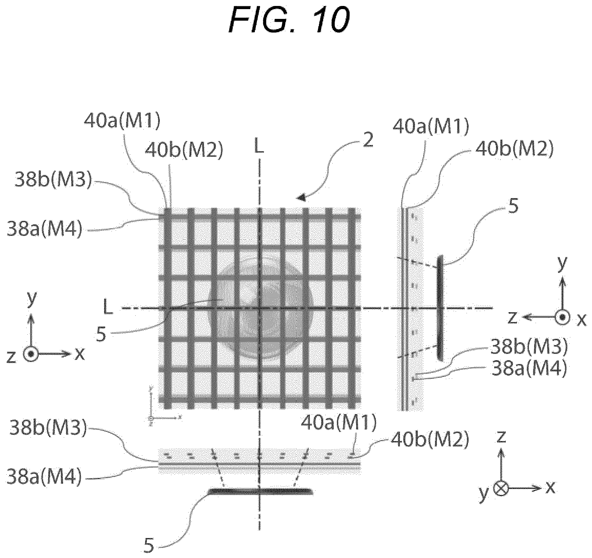

Fig. 10 is a plan view, a front view, and a side view illustrating a wiring example of the display panel 2 shown in a wider range. Fig. 10 illustrates the first wiring line 38a in the layer M4 and the second wiring line 38b in the layer M3 that are scanned in the x direction (first direction), and the third wiring line 40a in the layer M1 and the fourth wiring line 40b in the layer M2 that are scanned in the y direction (second direction). The wiring lines 38a and 38b are arranged so as to have the relationship of the formula (1). Similarly, the wiring lines 40a and 40b are arranged so as to have the relationship of the formula (1). With this arrangement, the overlapping of projection images on the sensor 5 can be reduced as a whole of the wiring lines. As described above, the combination of the first wiring line 38a and the second wiring line 38b has the overlapping region with respect to the direction starting from the range of the objective surface of the sensor 5, the range being the predetermined range of the optical system that receives light or emits light via the first wiring line 38a and the second wiring line 38b. Similarly, the combination of the third wiring line 40a and the fourth wiring line 40b has the overlapping region with respect to the direction starting from the range of the objective surface of the sensor 5, the range being the predetermined range of the optical system that receives light or emits light via the third wiring line 40a and the fourth wiring line 40b.

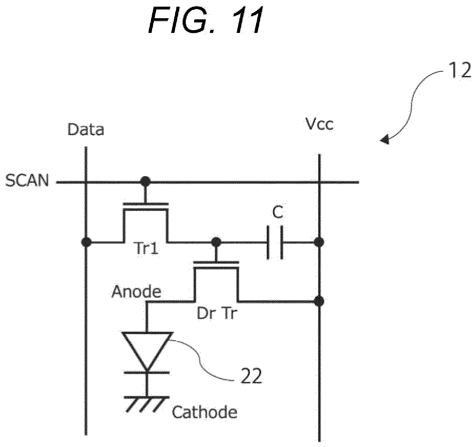

Fig. 11 is a circuit diagram illustrating a basic configuration of a pixel circuit 12 including the OLED 22. The pixel circuit 12 in Fig. 11 includes a drive transistor DrTr, a sampling transistor Tr1, and a pixel capacitor C, in addition to the OLED 22. The sampling transistor Tr1 is connected between a signal line Data and the gate of the drive transistor DrTr. A scanning line Scan is connected to the gate of the sampling transistor Tr1. The pixel capacitor C is connected between the gate of the drive transistor DrTr and the anode electrode of the OLED 22. The drive transistor DrTr is connected between a power supply voltage node Vcc and the anode of the OLED 22.

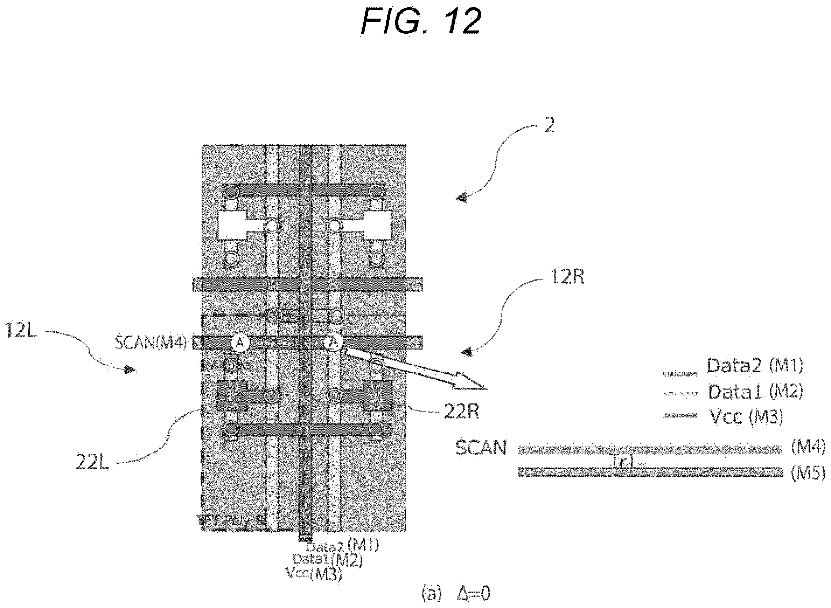

Fig. 12 is a diagram illustrating an arrangement example of pixel circuits 12L and 12R in the display panel 2. The left diagram is a plan view, and the right diagram is an A-A cross-sectional view. This is an example of $\Delta = 0$ in the formula (1), and the pixel circuits 12L and 12R are arranged symmetrically. The pixel circuits 12L and 12R are circuits equivalent to that in Fig. 11. A signal line Data1 (M2) is a signal line of the pixel circuit 12L, and a signal line Data2 (M1) is a signal line of the pixel circuit 12R. The power supply voltage node (constant potential line) Vcc (M3) is constituted commonly for the pixel circuits 12L and 12R. In this manner, by overlapping the signal line (first wiring line) Data1 (M2), the signal line (second wiring line) Data2 (M1), and the power supply voltage node (second' wiring line) Vcc (M3), the projection image area can be reduced. Note that the upper layer of the display panel 2 is defined as M1, and the lower layer thereof is defined as M6.

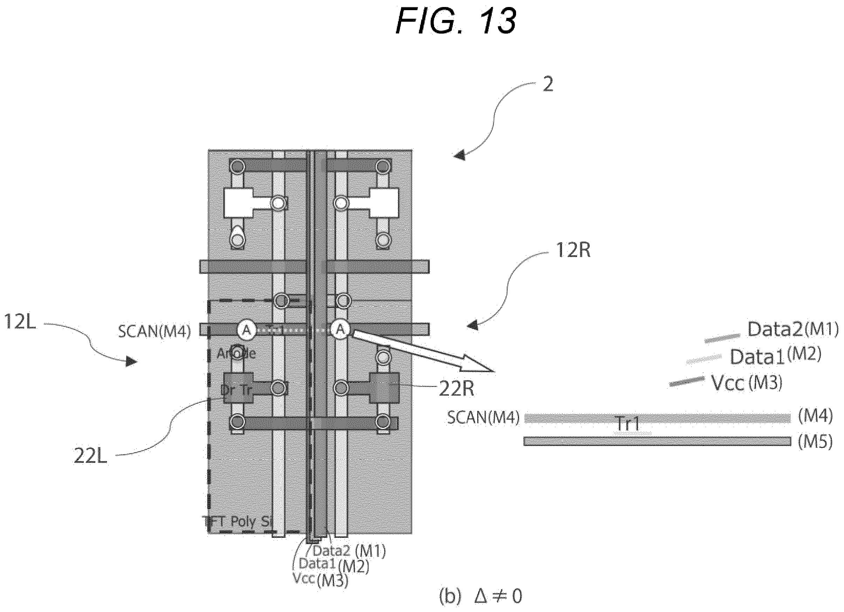

Fig. 13 is a diagram illustrating an arrangement example of the pixel circuits 12L and 12R in the display panel 2 in a case where $\Delta$ is not equal to zero. The left diagram is a plan view, and the right diagram is an A-A cross-sectional view. This is an example of $\Delta$ being not equal to zero in the formula (1), and the pixel circuits 12L and 12R are arranged symmetrically. The pixel circuits 12L and 12R are circuits equivalent to that in Fig. 11. A signal line Data1 (M2) is a signal line of the pixel circuit 12L, and a signal line Data2 (M1) is a signal line of the pixel circuit 12R. The power supply voltage node Vcc is constituted commonly for the pixel circuits 12L and 12R. As described above, by overlapping the signal line Data1 (M2), the signal line Data2 (M1), and the power supply voltage node Vcc (M3) in accordance with the formulas (1) and (2), the projection image area can be reduced. Note that the signal line (first wiring line) Data1, the signal line (second wiring line) Data2, and the power supply voltage node (second' wiring line) Vcc according to the present embodiment are provided in different layers (M1, M2, and M3), but the present invention is not limited thereto. For example, the signal line (first wiring line) Data1 and the signal line (second wiring line) Data2 may be provided in the same layer. In this case, the signal line (first wiring line) Data1 and the signal line (second wiring line) Data2 may be provided in the layer M1, and the power supply voltage node (second' wiring line) Vcc may be provided in the layer M2. Alternatively, the signal line (first wiring line) Data1 and the signal line (second wiring line) Data2 may be provided in the layer M2, and the power supply voltage node (second' wiring line) Vcc may be provided in the layer M1.

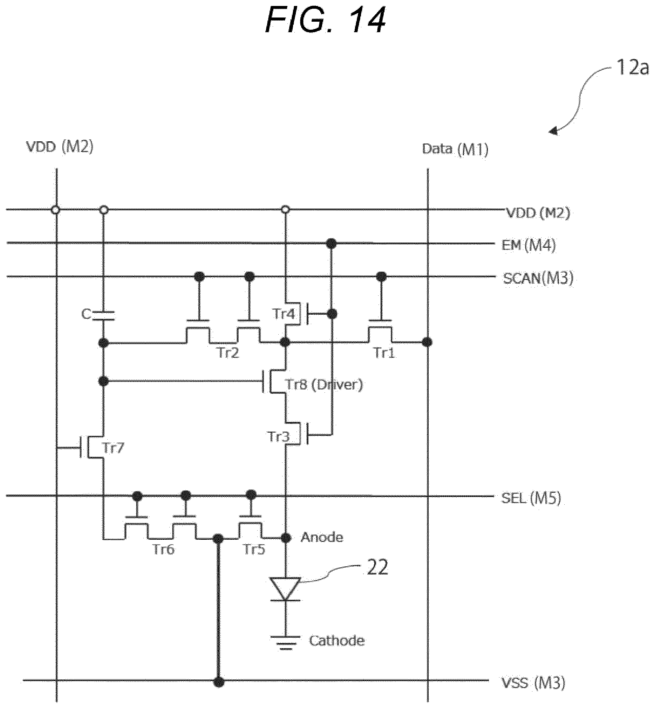

Fig. 14 is a circuit diagram illustrating another configuration of a pixel circuit 12a including the OLED 22. Fig. 14 illustrates a structure related to one pixel in the display device according to the embodiment of the present invention. An organic electroluminescent display device according to the present invention includes a plurality of gate lines, a plurality of data lines, a plurality of power supply lines, and a plurality of pixels each aligned in a corresponding one of the plurality of gate lines, a corresponding one of the plurality of data lines, and the common power supply line. Fig. 1 illustrates one pixel 12a aligned in the corresponding gate line, data line, and power supply line.

As illustrated in Fig. 14, the pixel circuit 12a includes eight transistors Tr1 to Tr8, a capacitor c, and the OLED 22. That is, the pixel circuit 12a includes the OLED 22 that emits light corresponding to an applied drive current, the transistor Tr1 for switching a data signal Data of a voltage level applied to the corresponding data line in response to a current scan line signal SCAN applied to the corresponding scan line, the drive transistor Tr8 that supplies the drive current of the OLED 22 in correspondence to the data voltage of a voltage level input to the gate via the transistor Tr1, and the capacitor c that stores the data signal applied to the gate of the drive transistor T8.

That is, the transistor Tr1 is connected to one end of the capacitor c via the signal line Data and the transistor Tr2. The other end of the capacitor c is connected to the power supply line VDD (M2). Furthermore, one end of the transistor Tr3 is connected to the drive transistor Tr8, the other end thereof is connected to the anode of the OLED 22, and the gate of the transistor Tr3 is connected to an EM line (M4). Furthermore, one end of the transistor Tr4 is connected to the power supply line VDD (M2), the other end is connected to one end of the drive transistor Tr8, and in addition, the gate of the transistor Tr4 is connected to the EM line (M4). One end of the transistor Tr5 is connected to the anode of the OLED 22, the other end thereof is connected to the VSS line (M3), and the gate of the transistor Tr5 is connected to an SEL line (M5). One end of the transistor Tr6 is connected to the VSS line (M3), the other end thereof is connected to the SEL line (M5), and the gate of the transistor Tr6 is connected to the SEL line (M5). The gate of the transistor Tr5 is connected to the SEL line (M5). One end of the transistor Tr6 is connected to the VSS line (M3), the other end thereof is connected to the SEL line (M5), and the gate of the transistor Tr6 is connected to the SEL line (M5). One end of the transistor Tr7 is connected to the capacitor c, the other end thereof is connected to the SEL line (M5), and the gate of the transistor Tr7 is connected to the VDD line (M2).

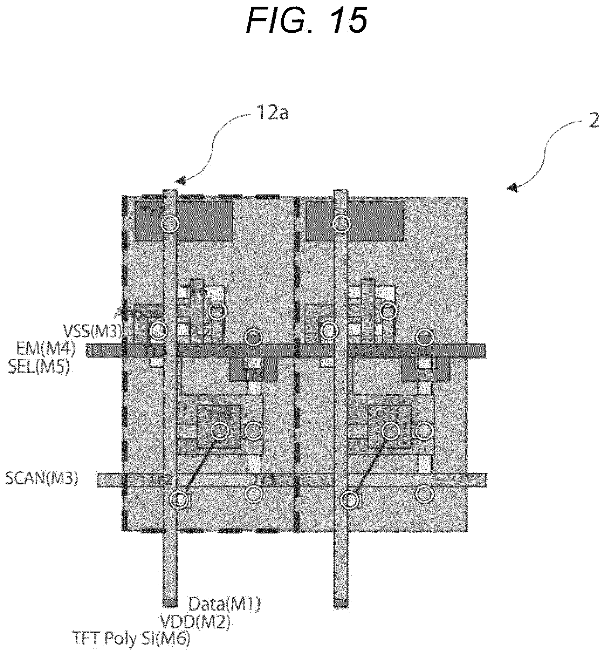

Fig. 15 is a plan view illustrating an arrangement example of the pixel circuit 12a in the display panel 2. This is an example of $\Delta = 0$ in the formula (1). The projection image area can be reduced by overlapping the signal line Data (first wiring line) (M1) and the power supply line VDD (second wiring line) (M2). Similarly, by overlapping the VSS line (third wiring line) (M3), the EM line (fourth wiring line) (M4), and the SEL line (fourth wiring line) (M5), the projection image area can be reduced.

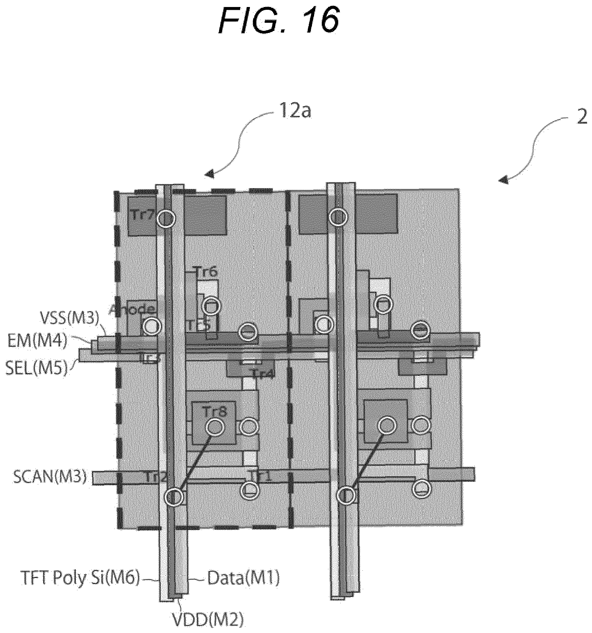

Fig. 16 is a plan view illustrating an arrangement example of the pixel circuit 12a in the display panel 2 in a case where $\Delta$ is not equal to zero. As described above, the projection image area can be reduced by overlapping the signal line Data (first wiring line) (M1) and the power supply line VDD (second wiring line) (M2) according to the formulas (1) and (2). Similarly, by overlapping the VSS line (third wiring line) (M3), the EM line (fourth wiring line) (M4), and the SEL line (fourth wiring line) (M5) according to the formulas (1) and (2), the projection image area can be reduced.

As described above, according to the present embodiment, the projection images of the plurality of wiring lines are arranged so as to overlap with each other with respect to the light receiving optical system or the light emitting optical system of the sensor 5 in the image display device 1. With this arrangement, the light transmittance with respect to the light receiving optical system or the light emitting optical system can be further improved.

(Second embodiment)

An image display device 1 according to a second embodiment is different from the image display device 1 according to the first embodiment in having a circular arc-shaped wiring structure. Hereinafter, differences from the image display device 1 according to the first embodiment will be described.

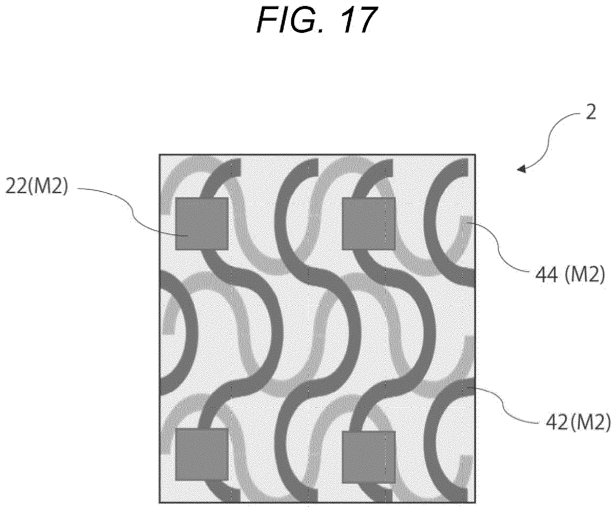

Fig. 17 is a plan view schematically illustrating a structure example inside a display panel 2. As illustrated in Fig. 17, in the display panel 2 using an OLED 22, circular arc-shaped opaque wiring lines 44 and 46 such as a power supply line and a scanning line for light emission control of the OLED 22 are scanned inside the transparent substrate. The wiring line 44 is arranged in a layer M2 and is used for driving the self light emitting element 22. For example, the wiring line 46 is arranged in the layer M2 so as to be laminated with the wiring line 44 with an insulating film interposed therebetween, and is used for driving the OLED 22.

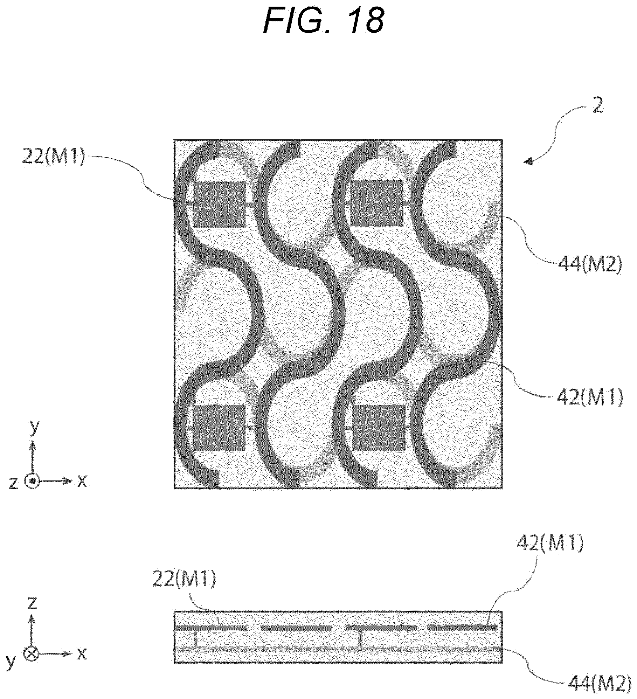

Fig. 18 is a plan view and a front view schematically showing another structure example inside the display panel 2. Layers M1 and M2 are set in this order from the upper layer of the display panel 2. As illustrated in Fig. 18, a circular arc-shaped first wiring line 42 and a circular arc-shaped second wiring line 44 are arranged in the layer M1 and the layer M2, respectively, and are arranged so as to overlap with each other in a case where the wiring lines are viewed from above. As can be seen from the above, the circular arc-shaped first wiring line 42 and the circular arc-shaped second wiring line 44 are arranged on different layers and are overlapped with each other.

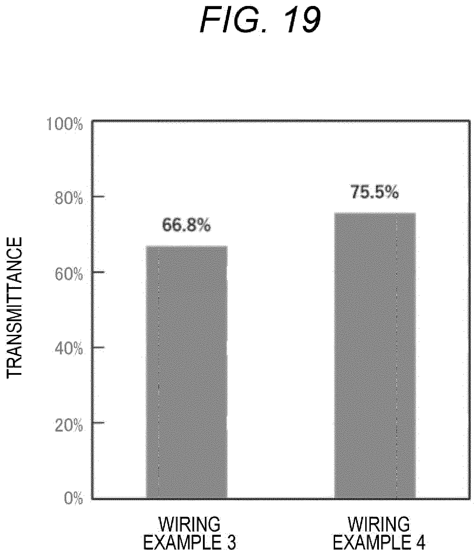

Fig. 19 is a diagram illustrating light transmittance of a wiring example 3 illustrated in Fig. 17 and a wiring example 4 illustrated in Fig. 18. The vertical axis represents light transmittance per unit area. For example, the transmittance is data obtained in a case where light having a wavelength of 550 nm is perpendicularly incident on the display panel 2. As can be seen, by overlapping the circular arc-shaped wiring lines 42 and 44 with each other, the transmittance is improved from 66.8 percent to 75.5 percent. As described above, by arranging the circular arc-shaped wiring lines 42 and 44 in different layers and overlapping the two with each other, the aperture ratio of the display panel 2 can be increased.

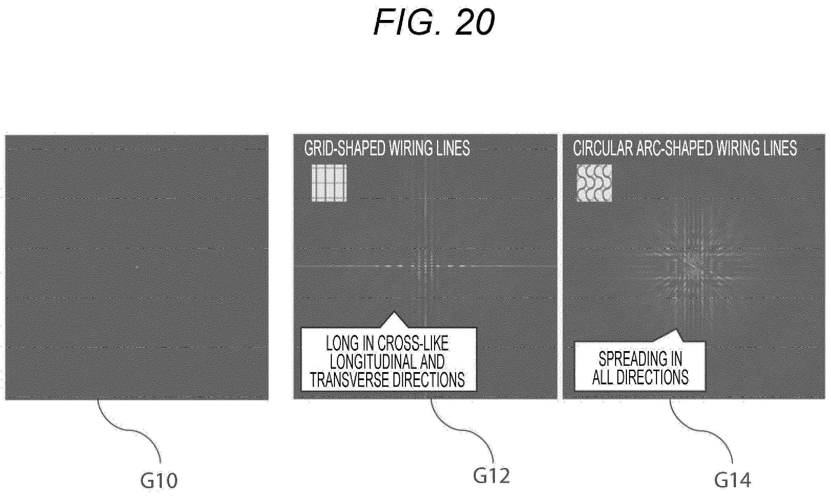

Fig. 20 is a diagram illustrating a diffraction simulation for grid-shaped wiring lines and circular arc-shaped wiring lines. Fig. G10 illustrates a point light source on the optical axis L (see Fig. 2A). Fig. G12 illustrates diffracted light in a case where the point light source in Fig. G10 is incident on the grid-shaped wiring lines, and Fig. G14 illustrates diffracted light in a case where the point light source in Fig. G10 is incident on the circular arc-shaped wiring lines. It can be seen that a strong light beam in a cross pattern is emitted in Fig. G12 which is the grid-shaped wiring lines, whereas light is scattered in all directions in Fig. G12 which is the circular arc-shaped wiring lines. As described above, the circular arc-shaped first wiring lines and the circular arc-shaped second wiring lines have, in a case where the light is incident on the circular arc-shaped first wiring lines and the circular arc-shaped second wiring lines, a shape that causes the light to scatter in all directions of a plane orthogonal to the optical axis L in a state where a scattering direction is suppressed from being biased.

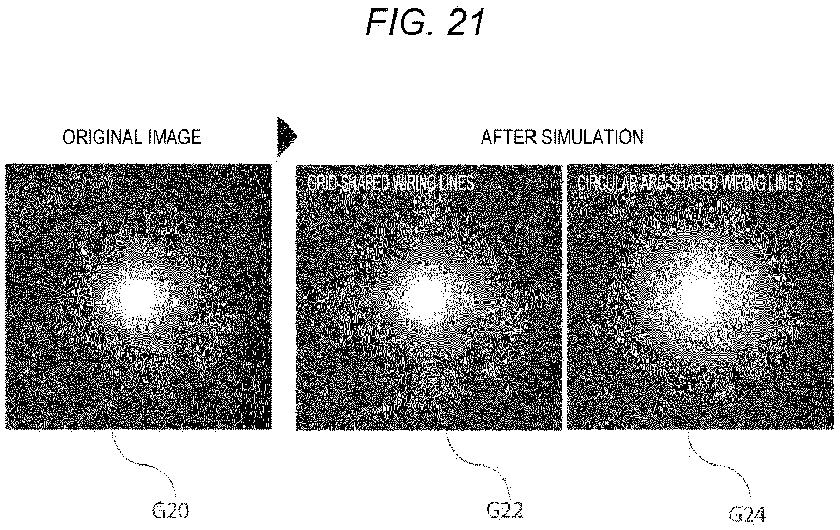

Fig. 21 is a diagram illustrating a diffraction simulation for natural light for the grid-shaped wiring lines and the circular arc-shaped wiring lines. Fig. G20 illustrates a surface light source that simulates the natural light. Fig. G22 illustrates diffracted light in a case where the surface light source in Fig. G20 is incident on the grid-shaped wiring lines, and Fig. G24 illustrates diffracted light in a case where the surface light source in Fig. G20 is incident on the circular arc-shaped wiring lines. A strong light beam in a cross pattern is emitted in Fig. G22 which is the grid-shaped wiring lines, whereas in Fig. G24 which is the circular arc-shaped wiring lines, light is scattered in all direction and a more natural image is generated. Furthermore, as can be seen from these, the pattern of the diffracted light can be adjusted by designing the circular arc shape of the wiring lines.

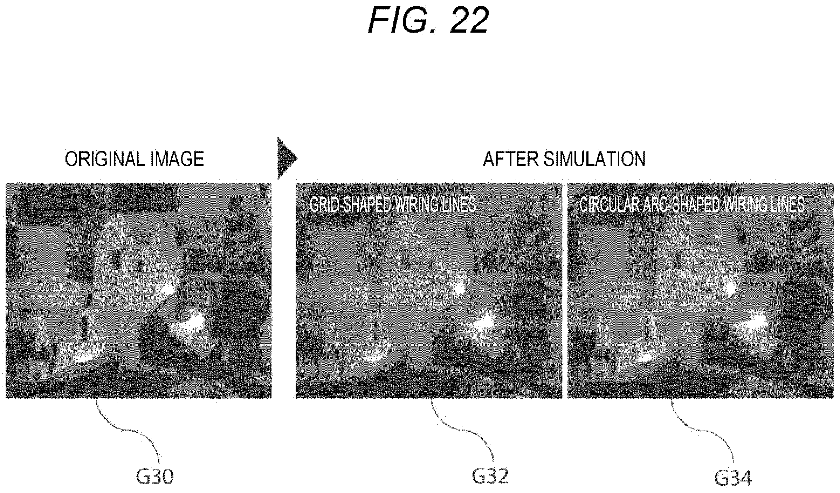

Fig. 22 is a diagram illustrating a diffraction simulation for another natural light for the grid-shaped wiring lines and the circular arc-shaped wiring lines. Fig. G30 illustrates a plurality of light sources that simulates the natural light. Fig. G32 illustrates diffracted light in a case where the plurality of light sources in Fig. G30 is incident on the grid-shaped wiring lines, and Fig. G34 illustrates diffracted light in a case where the plurality of light sources in Fig. G30 is incident on the circular arc-shaped wiring lines. A strong light beam in a cross pattern is emitted in Fig. G32 which is the grid-shaped wiring lines, whereas in Fig. G34 which is the circular arc-shaped wiring lines, light is scattered in all directions and a more natural image is generated.

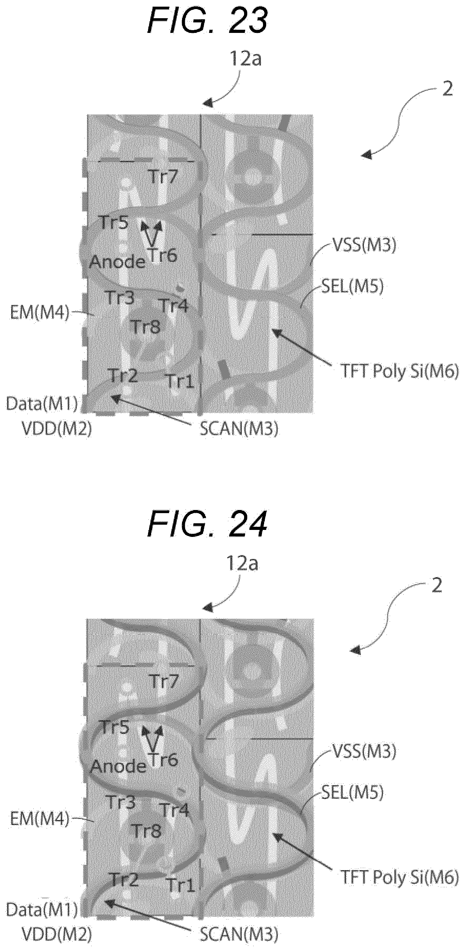

Fig. 23 is a plan view illustrating an arrangement example of a circular arc shape inside the display panel 2 in a pixel circuit 12a. This is an example of $\Delta = 0$ in the formula (1). The diffracted light can be suppressed by forming a Data line (M1), a VDD line (M2), a SCAN line (M3), an EM line (M4), and a SEL line (M5) in a circular arc shape. Furthermore, the projection image area can be reduced by overlapping the signal line Data (first wiring line) (M1), the power supply line VDD (second wiring line) (M2), the SCAN line (M3), and the EM line (fourth wiring line) (M4) with each other. Similarly, by overlapping the VSS line (third wiring line) (M3) and the SEL line (fourth wiring line) (M5), the projection image area can be reduced.

Fig. 24 is a plan view illustrating an arrangement example of a circular arc shape of the pixel circuit 12a inside the display panel 2 in a case where $\Delta$ is not equal to zero. In this manner, the diffracted light can be suppressed by forming the Data line (M1), the VDD line (M2), the SCAN line (M3), the EM line (M4), and the SEL line (M5) in a circular arc shape. Furthermore, the projection image area can be reduced by overlapping the signal line Data (first wiring line) (M1), the power supply line VDD (second wiring line) (M2), the SCAN line (M3), and the EM line (fourth wiring line) (M4) with each other according to the formulas (1) and (2). Similarly, by overlapping the VSS line (third wiring line) (M3) and the SEL line (fourth wiring line) (M5) according to the formulas (1) and (2), the projection image area can be reduced.

As described above, according to the present embodiment, the projection images of the plurality of circular arc-shaped wiring lines are arranged so as to overlap with each other with respect to the light receiving optical system or the light emitting optical system of the sensor 5 in the image display device 1. With this arrangement, the diffracted light due to the plurality of wiring lines can be suppressed. Furthermore, the light transmittance with respect to the light receiving optical system or the light emitting optical system can be further improved.

(Application example of image display device 1 and electronic device 50 according to present disclosure)

(First application example)

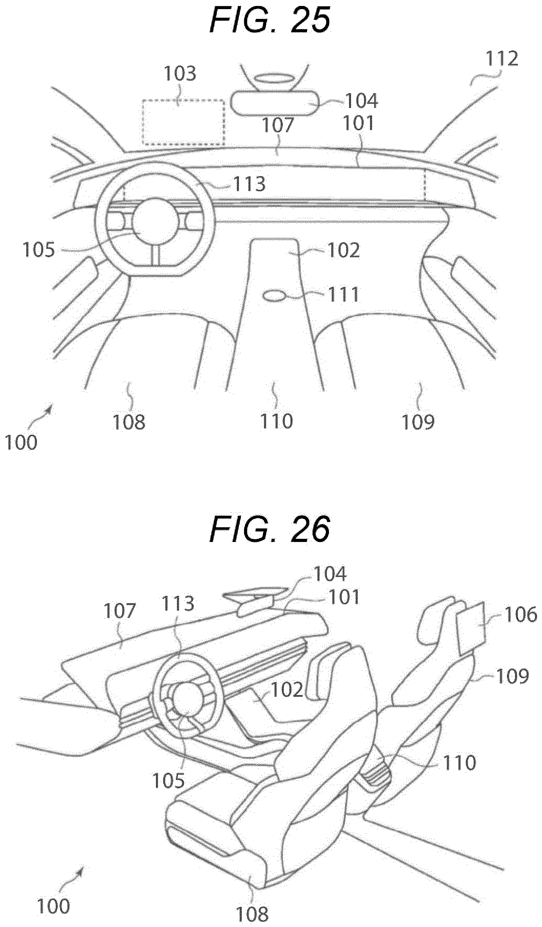

The image display device 1 and the electronic device 50 according to the present disclosure can be used for various purposes. Figs. 25 and 26 are views illustrating an internal configuration of a vehicle 100 as a first application example of the electronic device 50 including the image display device 1 according to the present disclosure. Fig. 25 is a view illustrating an internal state of the vehicle 100 from the rear side to the front side of the vehicle 100, and Fig. 26 is a view illustrating an internal state of the vehicle 100 from the oblique rear side to the oblique front side of the vehicle 100.

The vehicle 100 of Figs. 25 and 26 includes a center display 101, a console display 102, a head-up display 103, a digital rear mirror 104, a steering wheel display 105, and a rear entertainment display 106.

The center display 101 is arranged on a dashboard 107 at a location facing a driver seat 108 and a passenger seat 109. Fig. 38 illustrates an example of the center display 101 having a horizontally long shape extending from the driver seat 108 side to the passenger seat 109 side, but any screen size and arrangement location of the center display 101 may be adopted. The center display 101 can display information detected by the various sensors 5. As a specific example, the center display 101 can display a captured image captured by an image sensor, and a distance image to an obstacle in front of or on the side of the vehicle measured by a time of flight (ToF) sensor 5, a passenger's body temperature detected by an infrared sensor 5, and the like. The center display 101 can be used to display, for example, at least one of safety-related information, operation-related information, a life log, health-related information, authentication/identification-related information, or entertainment-related information.

The safety-related information is information of doze detection, looking-aside detection, detection of a child passenger getting into mischief, wearing or not wearing of a seat belt, detection of leaving of an occupant behind, and the like, and is information detected by the sensor 5 arranged, for example, to overlap with the back surface side of the center display 101. The operation-related information is information related to an operation by the occupant detected by using the sensor 5. The detected gesture may include an operation of various types of equipment in the vehicle 100. For example, operations of air conditioning equipment, a navigation device, an audio and visual (AV) device, a lighting device, and the like are detected. The life log includes life logs of all the occupants. For example, the life log includes an action record of each occupant in the vehicle. By acquiring and storing the life log, it is possible to check a state of the occupant at the time of an accident. In the health-related information, the health condition of the occupant is estimated on the basis of the body temperature of the occupant detected by using a temperature sensor 5. Alternatively, the face of the occupant may be captured by using the image sensor and the health condition of the occupant may be estimated from the captured facial expression of the occupant. Moreover, a conversation using the automatic voice may be made with the occupant, and the health condition of the occupant may be estimated on the basis of the content of the answer from the occupant. The authentication/identification-related information includes a keyless entry function of performing face authentication by using the sensor 5, a function of automatically adjusting a seat height and position by face identification, and the like. The entertainment-related information includes a function of detecting operation information of the AV device by the occupant by using the sensor 5, a function of recognizing the face of the occupant by the sensor 5 and providing a content suitable for the occupant by the AV device, and the like.

The console display 102 can be used, for example, to display the life log information. The console display 102 is arranged near a shift lever 111 of a center console 110 between the driver seat 108 and the passenger seat 109. The console display 102 can also display information detected by the various sensors 5. Furthermore, the console display 102 may display an image of the vehicle surroundings captured by the image sensor, or may display an image of a distance to an obstacle in the vehicle surroundings.

The head-up display 103 is virtually displayed behind a windshield 112 in front of the driver seat 108. The head-up display 103 can be used to display, for example, at least one of the safety-related information, the operation-related information, the life log, the health-related information, the authentication/identification-related information, or the entertainment-related information. Because the head-up display 103 is virtually arranged in front of the driver seat 108 in many cases, the head-up display 103 is suitable for displaying information directly related to an operation of the vehicle 100, such as a speed of the vehicle 100 and a remaining amount of fuel (battery).

The digital rear mirror 104 can not only display the rear side of the vehicle 100 but also a state of the occupant in the rear seat, and thus can be used to display, for example, the life log information by arranging the sensor 5 to overlap with the back surface side of the digital rear mirror 104.

The steering wheel display 105 is arranged near the center of a steering wheel 113 of the vehicle 100. The steering wheel display 105 can be used to display, for example, at least one of the safety-related information, the operation-related information, the life log, the health-related information, the authentication/identification-related information, or the entertainment-related information. In particular, because the steering wheel display 105 is close to the driver's hand, the steering wheel display 105 is suitable for displaying the life log information such as a body temperature of the driver, or for displaying information associated with an operation of the AV device, air conditioning equipment, or the like.

The rear entertainment display 106 is attached to the back side of the driver seat 108 and the passenger seat 109, and is for viewing by the occupant in the rear seat. The rear entertainment display 106 can be used to display, for example, at least one of the safety-related information, the operation-related information, the life log, the health-related information, the authentication/identification-related information, or the entertainment-related information. In particular, because the rear entertainment display 106 is in front of the occupant in the rear seat, information related to the occupant in the rear seat is displayed. For example, information associated with the operation of the AV device or the air conditioning equipment may be displayed, or a result of measuring the body temperature or the like of the occupant in the rear seat by the temperature sensor 5 may be displayed.

As described above, by arranging the sensor 5 to overlap with the back surface side of the image display device 1, a distance to an object that is present the surroundings can be measured. Optical distance measurement methods are roughly classified into a passive type and an active type. In the passive type method, a distance is measured by receiving light from the object without projecting light from the sensor 5 to the object. The passive type method includes a lens focus method, a stereo method, a monocular vision method, and the like. In the active type method, a distance is measured by projecting light onto the object and receiving reflected light from the object with the sensor 5. The active type method includes an optical radar method, an active stereo method, an illuminance difference stereo method, a moire topography method, an interference method, and the like. The image display device 1 according to the present disclosure can be applied to any of these types of distance measurement. By using the sensor 5 arranged to overlap with the back surface side of the image display device 1 according to the present disclosure, the distance measurement of the passive type or the active type described above can be performed.

(Second application example)

The image display device 1 according to the present disclosure is applicable not only to various displays used in vehicles but also to displays mounted on various electronic devices 50.

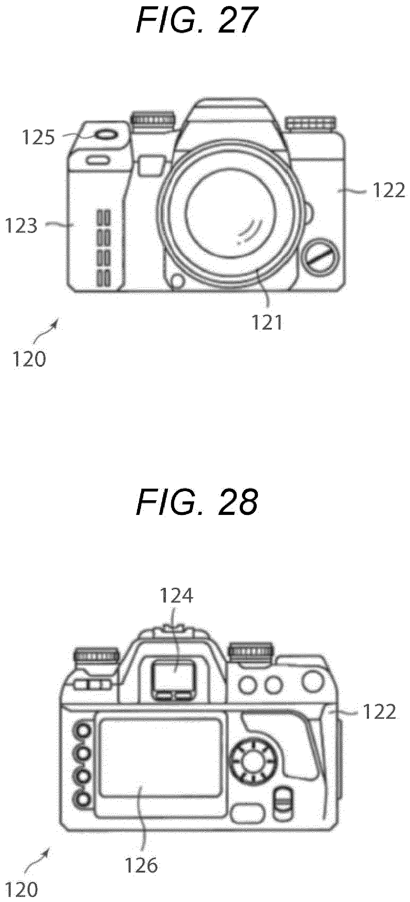

Fig. 27 is a front view of a digital camera 120 as a second application example of the electronic device 50, and Fig. 28 is a rear view of the digital camera 120. The digital camera 120 in Figs. 27 and 28 illustrates an example of a single-lens reflex camera in which a lens 121 is replaceable, but the image display device 1 is also applicable to a camera in which the lens 121 is not replaceable.

In the camera of Figs. 27 and 28, when a photographer looks into an electronic viewfinder 124 while holding a grip 123 of a camera body 122 to determine a composition and presses a shutter 125 while adjusting focus, captured data is stored in a memory in the camera. As illustrated in Fig. 28, on the back side of the camera, a monitor screen 126 that displays the captured data and the like and a live image and the like, and the electronic viewfinder 124 are provided. Furthermore, there is a case where a sub screen that displays setting information such as a shutter speed and an exposure value is provided on the upper surface of the camera.

By arranging a sensor 5 so as to overlap with the back surface side of the monitor screen 126, the electronic viewfinder 124, the sub screen, and the like used for the camera, the camera can be used as the image display device 1 according to the present disclosure.

(Third application example)

The image display device 1 according to the present disclosure is also applicable to a head mounted display (hereinafter, referred to as an HMD). The HMD can be used for virtual reality (VR), augmented reality (AR), mixed reality (MR), substitutional reality (SR), or the like.

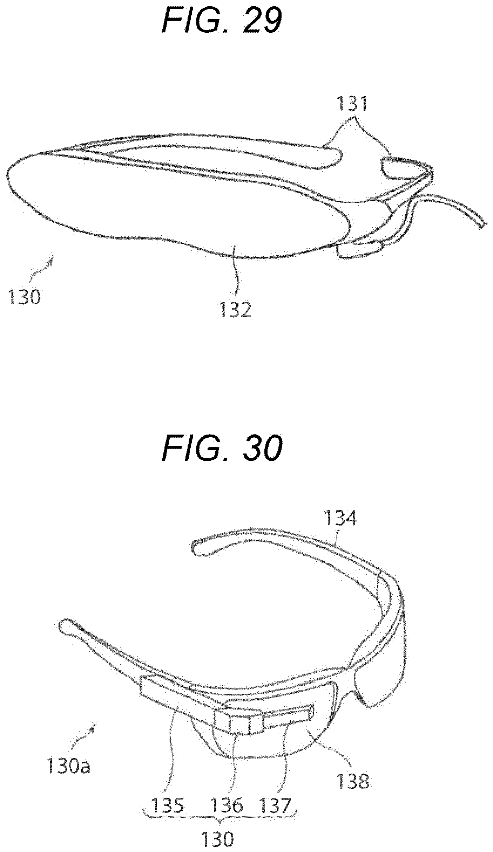

Fig. 29 is an external view of an HMD 130 as a third application example of the electronic device 50. The HMD 130 in Fig. 29 includes a mounting member 131 for attachment to cover human eyes. The mounting member 131 is, for example, hooked and fixed to human ears. A display device 132 is provided inside the HMD 130, and a wearer of the HMD 130 can visually recognize a stereoscopic image and the like with the display device 132. The HMD 130 includes, for example, a wireless communication function, an acceleration sensor, and the like, and can switch a stereoscopic image and the like displayed on the display device 132 in accordance with a posture, a gesture, and the like of the wearer.

Furthermore, a camera may be provided in the HMD 130 to capture an image around the wearer, and an image obtained by combining the captured image of the camera and an image generated by a computer may be displayed on the display device 132. For example, by arranging the camera to overlap with the back surface side of the display device 132 visually recognized by the wearer of the HMD 130, capturing an image of the surroundings of the eyes of the wearer with the camera, and displaying the captured image on another display provided on the outer surface of the HMD 130, a person around the wearer can grasp expression of the face and a movement of the eyes of the wearer in real time.

Note that various types of the HMD 130 are conceivable. For example, as illustrated in Fig. 30, the image display device 1 according to the present disclosure can also be applied to a smart glass 130a that displays various types of information on glasses 134. The smart glass 130a in Fig. 30 includes a main body portion 135, an arm portion 136, and a lens barrel portion 137. The main body portion 135 is connected to the arm portion 136. The main body portion 135 is detachable from the glasses 134. The main body portion 135 incorporates a display unit and a control board for controlling an operation of the smart glass 130a. The main body portion 135 and the lens barrel are connected to each other via the arm portion 136. The lens barrel portion 137 emits image light emitted from the main body portion 135 through the arm portion 136, to the lens 138 side of the glasses 134. This image light enters the human eyes through the lens 138. A wearer of the smart glass 130a in Fig. 30 can visually recognize not only a surrounding situation but also various pieces of information emitted from the lens barrel portion 137 similarly to normal glasses.

(Fourth application example)

The image display device 1 according to the present disclosure is also applicable to a television device (hereinafter, a TV). In recent TVs, a frame tends to be as small as possible from the viewpoint of downsizing and design properties. Therefore, in a case where a camera to capture an image of a viewer is provided on a TV, it is desirable to arrange the camera so as to overlap with the back surface side of a display panel 2 of the TV.

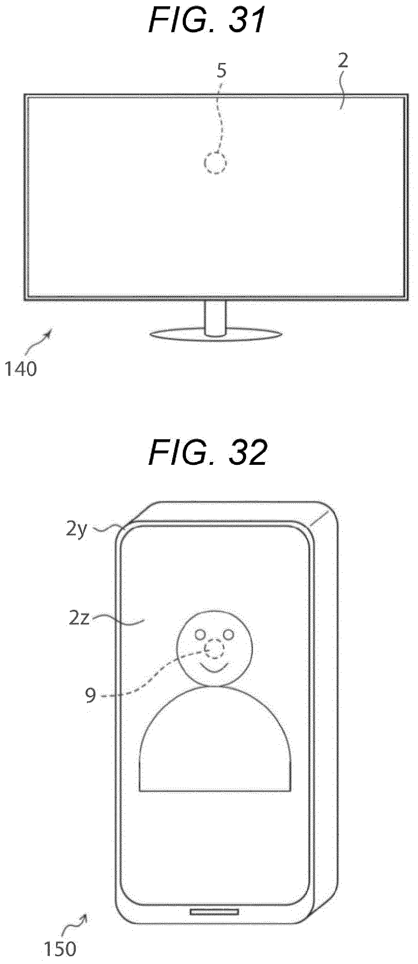

Fig. 31 is an external view of a TV 140 as a fourth application example of the electronic device 50. In the TV 140 of Fig. 31, the frame is minimized, and almost the entire region on the front side is a display area. The TV 140 incorporates a sensor 5 such as a camera to capture the image of the viewer. The sensor 5 in Fig. 31 is arranged on the back side of a part (for example, a broken line part) in the display panel 2. The sensor 5 may be an image sensor module, or various sensors can be applied such as a sensor for face authentication, a sensor for distance measurement, and a temperature sensor, and a plurality of types of sensors may be arranged on the back surface side of the display panel 2 of the TV 140.

As described above, according to the image display device 1 of the present disclosure, an image sensor module 9 can be arranged to overlap with the back surface side of the display panel 2. Therefore, there is no need to arrange a camera or the like on the frame, the TV 140 can be downsized, and there is no possibility that the design is impaired by the frame.

(Fifth application example)

The image display device 1 according to the present disclosure is also applicable to a smartphone and a mobile phone. Fig. 32 is an external view of a smartphone 150 as a fifth application example of the electronic device 50. In an example in Fig. 32, a display surface 2z extends nearly the outer shape size of the electronic device 50, and the width of a bezel 2y around the display surface 2z is set to several millimeters or less. In general, a front camera is often mounted on the bezel 2y, but in Fig. 32, as indicated by a broken line, an image sensor module 9 serving as the front camera is arranged on, for example, the back surface side of a substantially central portion of the display surface 2z. As described above, by providing the front camera on the back surface side of the display surface 2z in this manner, the front camera is no longer necessary to be arranged on the bezel 2y, and thus the width of the bezel 2y can be narrowed.

Note that the present technology can have the following configurations.

(1) An image display device including:

a plurality of first wiring lines provided in a first layer;
a plurality of second wiring lines provided in a second layer different from the first layer; and
a plurality of light emitting elements connected to the plurality of first wiring lines and the plurality of second wiring lines, in which
the first wiring lines and the second wiring lines have an overlapping region in a part of the first wiring lines and the second wiring lines with respect to a direction starting from a predetermined range of an optical component that receives light or emits light.

(2) The image display device according to (1), in which the first wiring lines and the second wiring lines each corresponding to corresponding one of the first wiring lines constitute a combination in which a deviation amount of the optical system with respect to an optical axis direction changes according to a difference in the direction.

(3) The image display device according to (1), in which the first wiring lines and the second wiring lines each corresponding to corresponding one of the first wiring lines constitute at least one combination, the at least one combination having regions that overlap with each other at least within an optical path range of the optical system with respect to an optical axis direction of the optical system.

(4) The image display device according to any one of (1) to (3), further including:

a plurality of third wiring lines wired in a third layer; and
a plurality of fourth wiring lines wired in a fourth layer different from the third layer and each corresponding to corresponding one of the plurality of third wiring lines, in which
the third wiring lines and the fourth wiring lines each corresponding to corresponding one of the third wiring lines constitute a combination including an overlapping region with respect to a direction starting from a predetermined range of the optical system that receives light or emits light via the plurality of third wiring lines and the plurality of fourth wiring lines.

(5) The image display device according to any one of (1) to (4), in which

the plurality of first wiring lines and the plurality of second wiring lines extend in a first direction, and
the plurality of third wiring lines and the plurality of fourth wiring lines extend in a second direction different from the first direction.

(6) The image display device according to (5), in which

the first direction and the second direction are orthogonal to each other.

(7) The image display device according to (6) to (7), in which

the plurality of light emitting elements is arranged in a two-dimensional array, and
the plurality of light emitting elements is arranged in a column or row direction that forms a predetermined angle with the first direction.

(8) The image display device according to any one of (1) to (7), in which the plurality of first wiring lines and the plurality of second wiring lines are wired in a circular arc shape.

(9) The image display device according to (8), in which

the plurality of first wiring lines and the plurality of second wiring lines have,
in a case where light is incident on the plurality of first wiring lines and the plurality of second wiring lines from a point light source on an optical axis of the optical system, a shape that causes the light to scatter in all directions of a plane orthogonal to the optical axis in a state where a scattering direction is suppressed from being biased.

(10) The image display device according to any one of (1) to (9), in which

the plurality of first wiring lines is signal lines each driving corresponding one of a plurality of light emitting elements, and
the plurality of second wiring lines is constant potential lines each driving corresponding one of a plurality of light emitting elements.

(11) The image display device according to any one of (1) to (10), in which

the first wiring lines are first data lines each driving corresponding one of first light emitting elements, and
the second wiring lines are second data lines each driving a second light emitting element adjacent to the first light emitting element.

(12) The image display device according to (5), in which

the plurality of first wiring lines is signal lines each driving corresponding one of a plurality of light emitting elements,
the plurality of second wiring lines is first constant potential lines each driving corresponding one of a plurality of light emitting elements,
the plurality of third wiring lines is scanning lines each driving corresponding one of a plurality of light emitting elements, and
the plurality of fourth wiring lines is second constant potential lines each driving corresponding one of a plurality of light emitting elements.

(13) An image display device including:

a plurality of first wiring lines having a circular arc shape and a plurality of second wiring lines having a circular arc shape; and
a plurality of light emitting elements connected to the plurality of first wiring lines and the plurality of second wiring lines, in which
the plurality of first wiring lines and the plurality of second wiring lines have,
in a case where light is incident on the plurality of first wiring lines and the plurality of second wiring lines from a point light source on an optical axis of an optical system that receives light or emits light via the plurality of first wiring lines and the plurality of second wiring lines, a shape that causes the light to scatter in all directions of a plane orthogonal to the optical axis in a state where a scattering direction is further suppressed from being biased.

(14) An electronic device including:

an image display device; and
a light receiving device including an optical component that receives light or emits light via the image display device, in which
the image display device includes:

a plurality of first wiring lines provided in a first layer;
a plurality of second wiring lines provided in a second layer different from the first layer; and
a plurality of light emitting elements connected to the plurality of first wiring lines and the plurality of second wiring lines, and
the first wiring lines and the second wiring lines have an overlapping region in a part of the first wiring lines and the second wiring lines with respect to a direction starting from a predetermined range of an optical component that receives light or emits light.

(15) An electronic device including:

an image display device; and
a light receiving device including an optical system that receives light or emits light through the image display device, in which
the image display device includes:

a plurality of first wiring lines having a circular arc shape;
a plurality of second wiring lines having a circular arc shape; and
a plurality of light emitting elements connected to the plurality of first wiring lines and the plurality of second wiring lines, in which
the plurality of first wiring lines and the plurality of second wiring lines have,
in a case where light is incident on the plurality of first wiring lines and the plurality of second wiring lines from a point light source on an optical axis of the optical system via the plurality of first wiring lines and the plurality of second wiring lines, a shape that causes the light to scatter in all directions of a plane orthogonal to the optical axis in a state where a scattering direction is suppressed from being biased.

Aspects of the present disclosure are not limited to the above-described individual embodiments, but include various modifications that can be conceived by those skilled in the art, and the effects of the present disclosure are not limited to the above-described contents. That is, various additions, modifications, and partial deletions are possible without departing from the conceptual idea and spirit of the present disclosure derived from the matters defined in the claims and equivalents thereof.

REFERENCE SIGNS LIST

1 Image display device
2 Display panel
9d Lens unit (Optical system)
24a, 24b, 26a, 26b, 28a, 28b, 30a, 30b, 32a, 33b, 34a, 34b, 36a, 36b, 38a, 38b, 40a, 40b Wiring line
50 Electronic device

**Claims**

1.  An image display device comprising:

a plurality of first wiring lines provided in a first layer;
a plurality of second wiring lines provided in a second layer different from the first layer; and
a plurality of light emitting elements connected to the plurality of first wiring lines and the plurality of second wiring lines, wherein
the first wiring lines and the second wiring lines have an overlapping region in a part of the first wiring lines and the second wiring lines with respect to a direction starting from a predetermined range of an optical component that receives light or emits light.

2.  The image display device according to claim 1, wherein the first wiring lines and the second wiring lines each corresponding to corresponding one of the first wiring lines constitute a combination in which a deviation amount of the optical system with respect to an optical axis direction changes according to a difference in the direction.

3. The image display device according to claim 1, wherein the first wiring lines and the second wiring lines each corresponding to corresponding one of the first wiring lines constitute at least one combination, the at least one combination having regions that overlap with each other at least within an optical path range of the optical system with respect to an optical axis direction of the optical system.

4. The image display device according to claim 1, further comprising:

   a plurality of third wiring lines wired in a third layer; and
   a plurality of fourth wiring lines wired in a fourth layer different from the third layer and each corresponding to corresponding one of the plurality of third wiring lines, wherein
   the third wiring lines and the fourth wiring lines each corresponding to corresponding one of the third wiring lines constitute a combination including an overlapping region with respect to a direction starting from a predetermined range of the optical system that receives light or emits light via the plurality of third wiring lines and the plurality of fourth wiring lines.

5. The image display device according to claim 1, wherein

   the plurality of first wiring lines and the plurality of second wiring lines extend in a first direction, and
   the plurality of third wiring lines and the plurality of fourth wiring lines extend in a second direction different from the first direction.

6. The image display device according to claim 5, wherein
   the first direction and the second direction are orthogonal to each other.

7. The image display device according to claim 6, wherein

   the plurality of light emitting elements is arranged in a two-dimensional array, and
   the plurality of light emitting elements is arranged in a column or row direction that forms a predetermined angle with the first direction.

8. The image display device according to claim 1, wherein the plurality of first wiring lines and the plurality of second wiring lines are wired in a circular arc shape.

9. The image display device according to claim 8, wherein

   the plurality of first wiring lines and the plurality of second wiring lines have,
   in a case where light is incident on the plurality of first wiring lines and the plurality of second wiring lines from a point light source on an optical axis of the optical system, a shape that causes the light to scatter in all directions of a plane orthogonal to the optical axis in a state where a scattering direction is suppressed from being biased.

10. The image display device according to claim 1, wherein

   the plurality of first wiring lines is signal lines each driving corresponding one of a plurality of light emitting elements, and
   the plurality of second wiring lines is constant potential lines each driving corresponding one of a plurality of light emitting elements.

11. The image display device according to claim 1, wherein

   the first wiring lines are first data lines each driving corresponding one of first light emitting elements, and
   the second wiring lines are second data lines each driving a second light emitting element adjacent to the first light emitting element.

12. The image display device according to claim 5, wherein

the plurality of first wiring lines is signal lines each driving corresponding one of a plurality of light emitting elements,

the plurality of second wiring lines is first constant potential lines each driving corresponding one of a plurality of light emitting elements,

the plurality of third wiring lines is scanning lines each driving corresponding one of a plurality of light emitting elements, and

the plurality of fourth wiring lines is second constant potential lines each driving corresponding one of a plurality of light emitting elements.

13. An image display device comprising:

a plurality of first wiring lines having a circular arc shape and a plurality of second wiring lines having a circular arc shape; and

a plurality of light emitting elements driven by the plurality of first wiring lines and the plurality of second wiring lines, wherein

the plurality of first wiring lines and the plurality of second wiring lines have,

in a case where light is incident on the plurality of first wiring lines and the plurality of second wiring lines from a point light source on an optical axis of an optical system that receives light or emits light via the plurality of first wiring lines and the plurality of second wiring lines, a shape that causes the light to scatter in all directions of a plane orthogonal to the optical axis in a state where a scattering direction is further suppressed from being biased.

14. An electronic device comprising:

an image display device; and

a light receiving device including an optical component that receives light or emits light via the image display device, wherein

the image display device includes:

a plurality of first wiring lines provided in a first layer;

a plurality of second wiring lines provided in a second layer different from the first layer; and

a plurality of light emitting elements connected to the plurality of first wiring lines and the plurality of second wiring lines, and

the first wiring lines and the second wiring lines have an overlapping region in a part of the first wiring lines and the second wiring lines with respect to a direction starting from a predetermined range of an optical component that receives light or emits light.

15. An electronic device comprising:

an image display device; and

a light receiving device including an optical system that receives light or emits light through the image display device, wherein

the image display device comprises:

a plurality of first wiring lines having a circular arc shape;

a plurality of second wiring lines having a circular arc shape; and

a plurality of light emitting elements connected to the plurality of first wiring lines and the plurality of second wiring lines, wherein

the plurality of first wiring lines and the plurality of second wiring lines have,

in a case where light is incident on the plurality of first wiring lines and the plurality of second wiring lines from a point light source on an optical axis of the optical system via the plurality of first wiring lines and the plurality of second wiring lines, a shape that causes the light to scatter in all directions of a plane orthogonal to the optical axis in a state where a scattering direction is suppressed from being biased.

# FIG. 1A

# FIG. 1B

## FIG. 2A

## FIG. 2B

# FIG. 3

2

5

# FIG. 4

2

24b(M2)

22(M1)

20

24a(M2)

26a(M1)

26b(M1)

y
z → x

# FIG. 5

# FIG. 6

# FIG. 7

# FIG. 8

# FIG. 9

# FIG. 10

# FIG. 11

# FIG. 12

(a)  Δ=0

# FIG. 13

2

12R

12L

SCAN(M4)

Anode

Dr Tr

22L

22R

TFT Poly Si

Data2 (M1)
Data1 (M2)
Vcc (M3)

Data2 (M1)
Data1 (M2)
Vcc (M3)
SCAN(M4)        Tr1        (M4)
(M5)

(b)  $\Delta \neq 0$

EP 4 318 442 A1

# FIG. 14

# FIG. 15

12a

2

Tr7

Tr6

Anode

VSS(M3)

EM(M4)
SEL(M5)

Tr3

Tr4

Tr8

SCAN(M3)

Tr2

Tr1

Data(M1)
VDD(M2)
TFT Poly Si(M6)

# FIG. 16

# FIG. 17

22(M2)

2

44 (M2)

42(M2)

# FIG. 18

# FIG. 19

## FIG. 20

GRID-SHAPED WIRING LINES

LONG IN CROSS-LIKE
LONGITUDINAL AND
TRANSVERSE DIRECTIONS

CIRCULAR ARC-SHAPED WIRING LINES

SPREADING IN
ALL DIRECTIONS

G10

G12

G14

EP 4 318 442 A1

*FIG. 21*

## FIG. 22

ORIGINAL IMAGE

AFTER SIMULATION

GRID-SHAPED WIRING LINES

CIRCULAR ARC-SHAPED WIRING LINES

G30

G32

G34

## FIG. 23

12a

2

Tr7

Tr5

Anode Tr6

VSS(M3)

SEL(M5)

EM(M4)

Tr3    Tr4

Tr8

TFT Poly Si(M6)

Tr2    Tr1

Data(M1)

VDD(M2)    SCAN(M3)

## FIG. 24

12a

2

Tr7

Tr5

Anode Tr6

VSS(M3)

SEL(M5)

EM(M4)

Tr3    Tr4

Tr8

TFT Poly Si(M6)

Tr2    Tr1

Data(M1)

VDD(M2)    SCAN(M3)

## FIG. 25

## FIG. 26

# FIG. 27

# FIG. 28

# FIG. 29

131

130

132

# FIG. 30

134

130a

135 136 137

138

130

# FIG. 31

# FIG. 32

## INTERNATIONAL SEARCH REPORT

| International application No. |
| --- |
| **PCT/JP2022/006936** |

| A. | CLASSIFICATION OF SUBJECT MATTER |
| --- | --- |

*G09F 9/00*(2006.01)i; *G09F 9/30*(2006.01)i; *H01L 27/32*(2006.01)i; *H05B 33/02*(2006.01)i; *H01L 51/50*(2006.01)i
FI:   G09F9/30 338; G09F9/00 366A; G09F9/30 340; H01L27/32; H05B33/02; H05B33/14 A

According to International Patent Classification (IPC) or to both national classification and IPC

| B. | FIELDS SEARCHED |
| --- | --- |

Minimum documentation searched (classification system followed by classification symbols)

G09F9/00-9/46; H01L27/32; H01L51/50; H05B33/00-33/28; H05B45/60

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | US 10756136 B1 (WUHAN TIANMA MICRO-ELECTRONICS CO., LTD.) 25 August 2020 (2020-08-25) | 1, 3-7, 10-12, 14 |
|   | column 3, line 40 to column 6, line 18, fig. 1-7 |   |
| Y | column 3, line 40 to column 6, line 18, fig. 1-7 | 8-9, 13, 15 |
| Y | CN 109073941 A (ESSILOR INTERNATIONAL (COMPAGNIE GENERALE D'OPTIQUE)) 21 December 2018 (2018-12-21) | 8-9, 13, 15 |
|   | paragraphs [0059]-[0063], [0086]-[0091], fig. 1-3 |   |
| A | CN 111063719 A (WUHAN TIANMA MICRO-ELECTRONICS CO., LTD.) 24 April 2020 (2020-04-24) | 1-15 |
|   | entire text, all drawings |   |
| A | JP 2021-502603 A (YUNGU (GUAN) TECHNOLOGY CO., LTD.) 28 January 2021 (2021-01-28) | 1-15 |
|   | entire text, all drawings |   |

☑ Further documents are listed in the continuation of Box C.     ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **08 April 2022** | **10 May 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

| International application No. |
| --- |
| **PCT/JP2022/006936** |

## C.    DOCUMENTS CONSIDERED TO BE RELEVANT

| Category* | Citation of document, with indication, where appropriate, of the relevant passages | Relevant to claim No. |
| --- | --- | --- |
| A | US 2014/0098308 A1 (SHANGHAI TIANMA MICRO-ELECTRONICS CO., LTD.) 10 April 2014 (2014-04-10)<br>    entire text, all drawings | 1-15 |
| A | US 2020/0012672 A1 (RELX INC.) 09 January 2020 (2020-01-09)<br>    entire text, all drawings | 1-15 |

Form PCT/ISA/210 (second sheet) (January 2015)

**INTERNATIONAL SEARCH REPORT**
Information on patent family members

International application No.

**PCT/JP2022/006936**

| Patent document cited in search report | | | Publication date (day/month/year) | Patent family member(s) | | | Publication date (day/month/year) |
|---|---|---|---|---|---|---|---|
| US | 10756136 | B1 | 25 August 2020 | CN 110061014 A paragraphs [0032]-[0041], fig. 1-7 | | | |
| CN | 109073941 | A | 21 December 2018 | US 2019-0146244 A1 paragraphs [0058]-[0062], [0085]-[0090], fig. 1-3 EP 003452871 A1 | | | |
| CN | 111063719 | A | 24 April 2020 | (Family: none) | | | |
| JP | 2021-502603 | A | 28 January 2021 | US 2020-0212163 A1 entire text, all drawings EP 003675198 A1 CN 110767825 A KR 10-2020-0066729 A | | | |
| US | 2014/0098308 | A1 | 10 April 2014 | EP 002824508 A1 entire text, all drawings CN 103268044 A | | | |
| US | 2020/0012672 | A1 | 09 January 2020 | JP 2019-514124 A entire text, all drawings CN 109690528 A EP 003440562 A1 | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011175962 A